# EUROPÄISCHE PATENTSCHRIFT

(11) **EP 2 160 759 B1**
(45) Veröffentlichungstag und Bekanntmachung des Hinweises auf die Patenterteilung: **10.08.2011**
(21) Anmeldenummer: 08759870.2
(22) Anmeldetag: 21.05.2008
(51) Int. Cl.: H01L 21/687, C23C 16/458, C30B 25/12

(54) **VORRICHTUNG ZUM BESCHICHTEN EINER VIELZAHL IN DICHTESTER PACKUNG AUF EINEM SUSZEPTOR ANGEORDNETER SUBSTRATE**
DEVICE FOR COATING A PLURALITY OF CLOSEST-PACKED SUBSTRATES ARRANGED ON A SUSCEPTOR
DISPOSITIF POUR LE REVÊTEMENT D'UNE PLURALITÉ DE SUBSTRATS PLACÉS EN EMPILEMENT TRÈS COMPACT SUR UN SUSCEPTEUR

(30) Priorität: 23.05.2007 DE 102007023970
(43) Veröffentlichungstag der Anmeldung: 10.03.2010
(73) Patentinhaber: Aixtron SE, 52134 Herzogenrath (DE)
(72) Erfinder: BOYD, Adam, 4720 Kelmis (BE); SAYWELL, Victor, Suffolk IP31 2SW (GB); MULDER, Jan, 5627 TN Eindhoven (NL); FERON, Olivier, Hsinchu (TW); KÄPPELER, Johannes, 52146 Würselen (DE)
(74) Vertreter: Grundmann, Dirk
(86) Internationale Anmeldenummer: PCT/EP2008/056268
(87) Internationale Veröffentlichungsnummer: WO 2008/142115

(56) Entgegenhaltungen:
- EP-A- 0 045 057
- WO-A-02/18672
- WO-A-79/00510
- US-A- 5 814 196
- US-B1- 6 843 892

## Beschreibung

Die Erfindung betrifft eine Vorrichtung gemäß Gattungsbegriff des Anspruches 1.

Eine gattungsgemäße Vorrichtung wird von der WO79/00510 A beschrieben, bei der auf einer Auflagefläche liegende Substrate mittels Anlageflanke randgefasst werden. Die Anlageflanken werden von Rippen ausgebildet, die sich um den Substratrand erstrecken.

Die EP 0045057 A beschreibt eine Halterung für kreisförmige Substrate. Jedes Substrat liegt in einer Vertiefung, deren Wandung ringförmig geschlossen ist.

Aus der US 6,843,892 B1 ist eine Beschichtungseinrichtung für Festklappen mit einer Aufnahmevorrichtung für eine Vielzahl von Substraten in einer hexagonalen Anordnung bekannt.

Die US 5,814,196 beschreibt eine Beschichtungsvorrichtung, bei der die Substrate in Vertiefungen einliegen, wobei die Ränder der Vertiefungen der Umrisskontur der Substrate angepasst sind. Die Böden der Vertiefungen bilden Auflageflächen für die Substrate. Die Zentren der Substrate liegen auf Eckpunkten gleichseitiger Dreiecke.

Aus der US 2003/0109139 A1 ist eine Vorrichtung zum Polieren von Substraten bekannt, bei denen jeweils drei Substrate auf planetenartigen Substratträgern aufliegen.

Die DE 10 2004 009130 A1 beschreibt eine Vorrichtung zum Beschichten einer Vielzahl regelmäßig auf einer Auflagefläche eines einer Prozesskammer zugehörigen Suszeptors angeordneter Substrate, wobei die Auflagefläche Anlageflanken ausbildet zur Randfassung jedes Substrates. Dort sind die Substrate auf insgesamt sechs drehbaren Scheiben angeordnet. Die drehbaren Scheiben sind in hexagonaler Anordnung um das Zentrum eines Suszeptors angeordnet.

Eine ähnliche Vorrichtung zeigt die DE 100 43 600 A1.

Bei den bekannten Vorrichtungen zum Beschichten einer Vielzahl von Substraten liegen die Substrate in kreisförmiger Anordnung um das Zentrum eines Suszeptors. In einer ersten Reihe liegen beispielsweise vier Substrate gleichmäßig verteilt um das Zentrum des Suszeptors. Die Substrate liegen dabei in Ein-zelvertiefungen der Suszeptoroberfläche, wobei die Zentren der Einzelvertiefungen auf einer Kreislinie um das Zentrum verlaufen. In einem zweiten Kreis um das Zentrum liegen zehn Substrate ebenfalls jeweils in Einzelvertiefungen ein. In einem dritten Kreis um das Zentrum liegen sechzehn Substrate in entsprechender Weise in Einzelvertiefungen, deren Zentren denselben Abstand zum Zentrum des Suszeptors besitzen.

Eine derartige Anordnung von Substraten auf einem Suszeptor bringt gewisse Vorteile. Oberhalb der Auflagefläche des Suszeptors befindet sich die Prozesskammer, in die von oben über ein Gaseinlassorgan Prozessgase eingeleitet werden. Diese Prozessgase reagieren entweder in der Gasphase oder auf den Oberflächen der zu beschichtenden Substrate, wobei Elemente der Prozessgase unter Ausbildung einer Schicht auf den Substraten abgeschieden werden. Hierzu wird der Suszeptor in der Regel von unten beheizt.

Es ist grundsätzlich nicht zu vermeiden, dass in den Zwischenräumen des Suszeptors zwischen den Einzelvertiefungen parasitäres Wachstum stattfindet. Das parasitäre Wachstum hat nicht nur eine ungewünschte Verarmung der Gasphase zur Folge, sondern beeinflusst auch negativ die Homogenität der abgeschiedenen Schichten.

Der Erfindung liegt daher die Aufgabe zugrunde, die bekannte Vorrichtung gebrauchsvorteilhaft zu verbessern.

Gelöst wird die Aufgabe durch die in den Ansprüchen angegebene Erfindung, wobei jeder Anspruch eine eigenständige Lösung der Aufgabe darstellt und mit jedem anderen Anspruch kombinierbar ist.

Der von der Erfindung eingeschlagene Lösungsweg sieht die Minimierung der freien Substratoberflächen zwischen den Substraten vor. Hierzu wird zunächst vorgeschlagen, dass die Anlageflanken, an denen die Ränder des Substrates liegen, von den Seitenwandungen aus der Anlagefläche ragenden Sockeln ausgebildet sind. Hierzu ist es von Vorteil, wenn die Sockel auf den Eckpunkten einer Wabenstruktur angeordnet sind. Die Sockel können derart voneinander beabstandet sein, dass sich Randabschnitte benachbarter Substrate berühren oder nahezu berühren. Die Randkanten der Sockel folgen den Randkanten des Substrates. Da die Substrate in der Regel im wesentlichen kreisförmig ausgebildet sind, besitzen die Seitenwände der Sockel einwärts gekrümmte Seiten. Die sich dabei ergebenden Eckpunkte des Sockels liegen auf den Eckpunkten eines gleichseitigen Dreiecks, so dass der Grundriss des Sockels im wesentlichen dem eines gleichseitigen Dreiecks mit einwärts gekrümmten Seiten entspricht. Die Sockel entspringen bevorzugt dem Boden einer Vertiefung in der zur Prozesskammer hinweisenden Breitseite des Substrathalters. Es ist ferner von Vorteil, wenn die Sockel aus einem anderen Material als das Material des Suszeptors gefertigt sind. Der Suszeptor wird üblicherweise aus Graphit oder einem Metall gefertigt. Er kann aber auch aus Quarz gefertigt sein. Die Sockel können in diesem Falle als Einsteckteile ausgebildet sein, die in Einstecköffnungen der Auflagefläche eingesteckt sind. Besonders bevorzugt bestehen die Sockel aus demselben Material, aus dem auch die zwischen den Sockeln angeordneten Substrate bestehen, also aus Saphir oder aus einem Halbleitermaterial. Die physikalischen und chemischen Eigenschaften der Sockeloberflächen entsprechen dann den chemischen und physikalischen Eigenschaften der Substratoberflächen. Die Sockelhöhe entspricht im wesentlichen der Materialstärke der Substrate. Da die Randkanten der Substrate in nahezu berührender Anlage an den gekrümmten Seitenwänden der Sockel anliegen, ergibt sich eine Oberfläche des mit Substraten belegten Suszeptors, die nur einen scher geringe Anteil besitzt, der nicht die physikalischen und chemischen Eigenschaften des Substrates aufweist. Zufolge dieser Ausgestaltung kann die Schichthomogenität gesteigert werden. In einer Weiterbildung der Erfindung ist vorgesehen, dass die Substrate wie beim Stand der Technik auch in ihnen individuell zugeordneten Einzelvertiefungen einliegen. Wesentlich ist hier aber, dass die Zentren der Einzelvertiefungen auf den Eckpunkten eines aus gleichseitigen Dreiecken bestehenden Gitters liegen. Dabei ist die Gitterkonstante, also der Abstand der Eckpunkte voneinander, nur geringfügig größer als der Durchmesser der Substrate. Auch hier bilden die Einzelvertiefungen auf einer Kreisbogenlinie verlaufende Anlageflächen für die Ränder der Substrate aus. Im Zentrum zwischen den Eckpunkten des jeweiligen Dreiecks befindet sich ein im wesentlichen dreieckiger Sockel mit einwärts gekrümmten Seitenwänden. Die Seitenwände schneiden sich aber nicht in Ecken des Sockels, sondern gehen unter Ausbildung einer Materialbrücke in einen benachbarten Sockel über. Auch bei dieser Lösung ist die freie, von den Substraten nicht bedeckte Oberfläche des Suszeptors minimiert.

Ausführungsbeispiele der Erfindung werden nachfolgend anhand beigefügter Zeichnungen erläutert. Es zeigen:
- Fig. 1: die Draufsicht auf die Anlagefläche eines Suszeptors eines ersten Aus- führungsbeispiels, der zu Demonstrationszwecken nur teilweise mit Substraten 3 belegt ist;
- Fig. 2: eine Darstellung gemäß Fig.1, wobei die Mittelpunkte von dreieckigen Sockeln 4 zur Verdeutlichung einer Wabenstruktur mit Hilfslinien 7 miteinander verbunden sind;
- Fig. 3: den vergrößerten Ausschnitt gemäß III in Fig. 1;
- Fig. 4: einen Schnitt gemäß der Linie IV - IV in Fig. 3;
- Fig. 5: eine Darstellung gemäß Fig. 4 eines zweiten Ausführungsbeispiels;
- Fig. 6: eine Darstellung gemäß Fig. 1 eines dritten Ausführungsbeispiels und
- Fig. 7: in schematischer Darstellung der zur Erläuterung der Erfindung we- sentlichen Details der erfindungsgemäßen Vorrichtung.

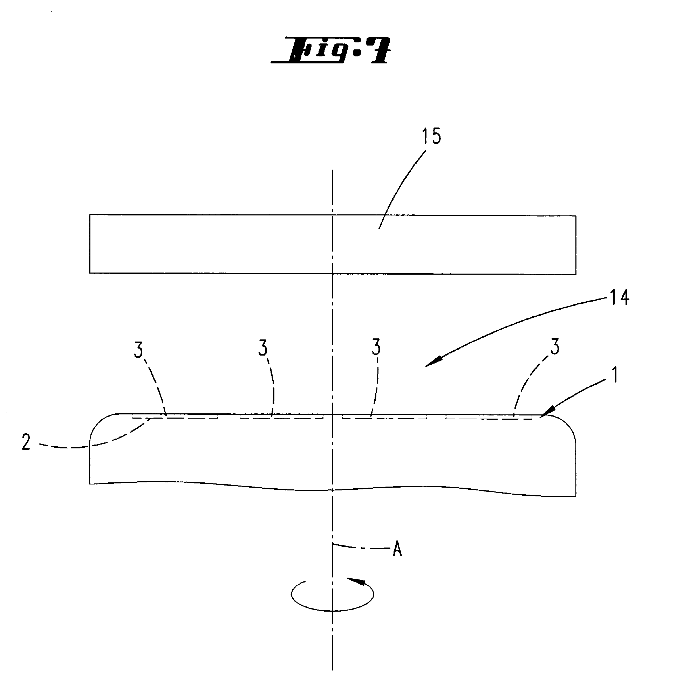

Die Figur 7 beschreibt das Innere eines Reaktorgehäuses einer Vorrichtung zum Beschichten einer Vielzahl auf einem Suszeptor 1 angeordneter Substrate 3. Der Suszeptor 1 besteht im wesentlichen aus einem Graphitkörper mit einer in einer Horizontalebene liegenden kreisförmigen Oberfläche, die eine Auflagefläche 2 für einen Vielzahl von Substraten ausbildet. Dieser, bis zu 40 cm Durchmesser aufweisende Suszeptor 1 kann um eine Drehachse A gedreht werden.

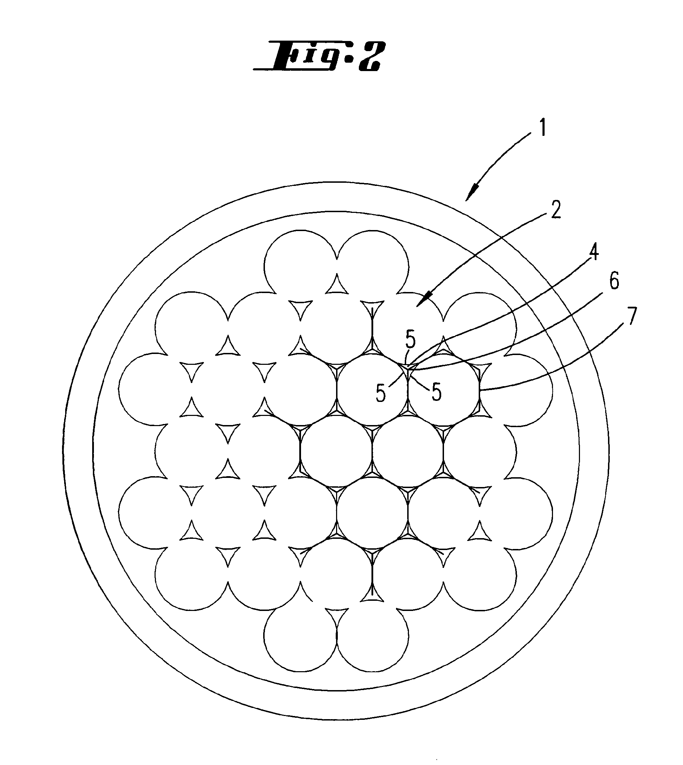

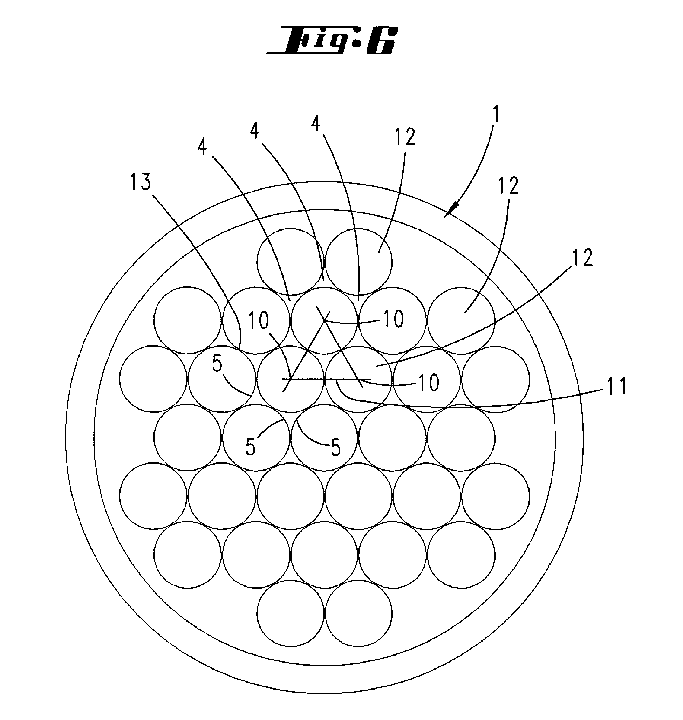

Oberhalb des Suszeptors 1 befindet sich die Prozesskammer 14, welche nach oben hin von der Unterseite eines Gaseinlassorganes 15 begrenzt wird. Durch nicht dargestellte Öffnungen, die duschkopfartig über die gesamte nach unten weisende Gasaustrittsfläche des Gaseinlassorganes 15 verteilt sein können, treten ein oder mehrere Prozessgase in die Prozesskammer 14 ein, um dort entweder in der Gasphase selbst oder von einer unterhalb des Suszeptors 1 angeordneten Heizung thermisch aktiviert auf der Substratoberfläche zu reagieren. Die Prozessgase enthalten Elemente der 4. Hauptgruppe oder Elemente der 3. und 5. Hauptgruppe oder Elemente der 2. und 6. Hauptgruppe. Es können Chloride, Hydride oder metallorganische Verbindungen durch das auch anders gestaltete Gaseinlassorgan in die Prozesskammer 14 eingeleitet werden. Die oben erwähnten Elemente der 2. bis 6. Hauptgruppe kondensieren unter Ausbildung einer insbesondere kristallinen Schicht auf der Oberfläche der auf dem Suszeptor 1 regelmäßig angeordneten Substrate 3. Zur Optimierung des Wachstums der Schichten auf den Substraten 3 sind die Substrate erfindungsgemäß in dichtester Packung auf dem Suszeptor angeordnet. Es ist eine hexagonale Anordnung der Substrate gewählt. Wie insbesondere den Figuren 2 und 6 zu entnehmen ist, liegen die Zentren 10 der Substrate 3 auf den Eckpunkten eines Gitters, bei dem jede Gitterzelle aus einem gleichseitigen Dreieck besteht. In der Figur 8 ist ein derartiges Gitter mit den Hilfslinien 11 dargestellt, die die Zentren 10 von Einzelvertiefungen 12 miteinander verbinden, in die jeweils ein Substrat 3 eingelegt werden kann. In der Figur 2 ist diese Struktur als Wabenstruktur dargestellt. Zufolge der hexagonalen Anordnung der Substrate 3 auf dem Suszeptor 1 ist die nicht von den Substraten bedeckte Freifläche des Suszeptors 1 minimiert.

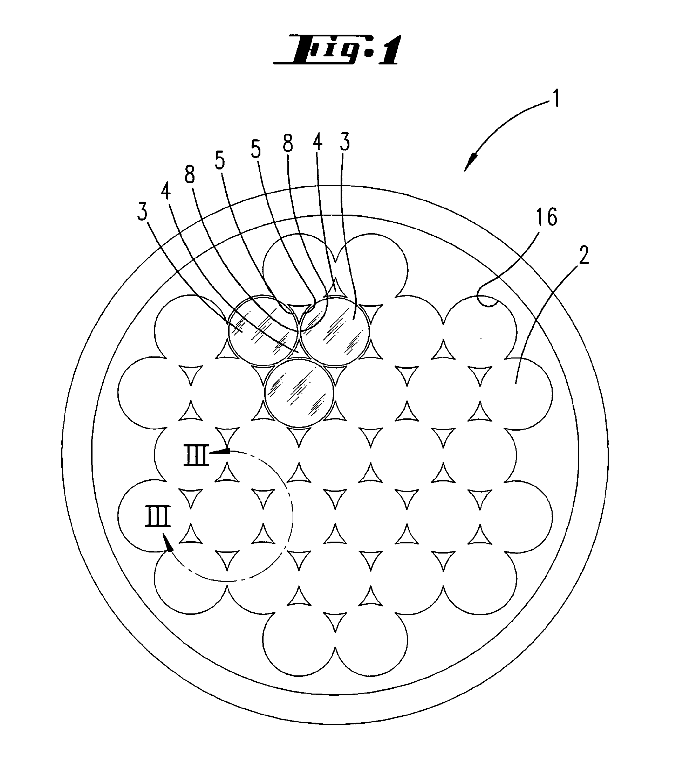

Bei dem in den Figuren 1 bis 4 dargestellten ersten Ausführungsbeispiel besitzt die in einer Horizontalebene und nach oben weisende Oberseite des Suszeptors 1 eine einzige große Vertiefung, die mit Auflagefläche 2 bezeichnet ist. Der äußere Rand der Auflagefläche 2 folgt dabei unter Ausbildung eines Vertiefungsrandes 16 Abschnitten der auf einer Kreisbogenlinie verlaufenden Ränder von in der Vertiefung liegenden Substraten.

Innerhalb der Auflagefläche 2 befinden sich aus dem Boden dieser die Auflagefläche 2 bildenden Vertiefung ragende Sockel 4. Wie durch die in der Figur 2 eingezeichneten Hilfslinien 7 kenntlich gemacht, liegen die Mittelpunkte 6 der Sockel auf den Gitterpunkten eines hexagonalen, nämlich wabenförmigen Gitters. In je einer dieser Gitterzellen befindet sich ein Substrat 3. Die Eckpunkte der Sockel 4 liegen auf den Eckpunkten eines gleichseitigen Dreiecks, wobei die Seitenwände 5 der Sockel 4 auf einwärts gekrümmten Linien verlaufen. Die Seitenwände 5 der Sockel 4 bilden Anlageflanken 5 für die Ränder 8 der jeweils zwischen sechs Sockeln angeordneten Substrate 3.

Zwischen den aufeinander zu weisenden Ecken zweier benachbarter Sockel 4 befindet sich ein Freiraum, in den Abschnitte 8 der Randkante der Substrate 3 derart hineinragen können, so dass sich die Randkanten 8 zweier benachbarter Substrate berühren können oder nur wenige 100stel Millimeter voneinander beanstandet sind. Die Freifläche auf der Oberfläche des Suszeptors 1 wird zufolge dieser Ausgestaltung von den zwickelförmigen Oberflächen der Sockel 4 ausgebildet. Der Abstand der Sockel 4 voneinander entspricht in etwa der Breitseitenerstreckung der Sockel 4. In den Figuren 1 und 2 liegen die Substrate 3 zentrisch in den zwischen sechs Sockeln angeordneten Aufnahmeplätzen. In einer exzentrischen Lage können Abschnitte der Ränder 8 die Verbindungslinie zwischen den Eckpunkten der Ecken zweier benachbarter Sockel 4 überschreiten.

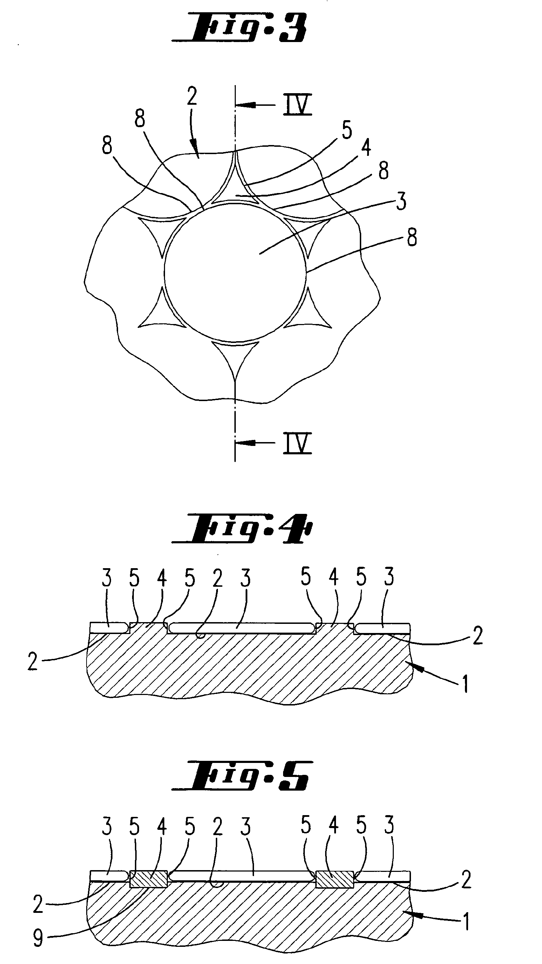

Wie aus der Figur 4 zu entnehmen ist, sind beim ersten Ausführungsbeispiel die Sockel 4 materialeinheitlich mit dem Suszeptor 1 verbunden. Letzterer kann aus Graphit, beschichtetem Graphit, einem Metall oder Quarz bestehen. Die Sockel 4 sind somit Erhebungen der Auflagefläche 2, auf denen die Substrate 3 aufliegen. Die Höhe der Sockel 4 entspricht im wesentlichen der Materialstärke der Substrate 3.

Die Figur 5 zeigt ein zweites Ausführungsbeispiel, bei dem die Sockel 4 eine Grundrisskontur aufweisen, wie sie in den Figuren 1 bis 3 dargestellt ist. Bei diesem Ausführungsbeispiel werden die Sockel 4 aber von Einsatzstücken ausgebildet, die materialfremd zum Suszeptor 1 ausgebildet sein können. Die die Sockel 4 ausbildenden Einsatzstücke stecken in Einstecköffnungen 9 der Auflagefläche 2. Auch hier überragen die Sockel 4 die Auflagefläche 2 um die Materialstärke der Substrate 3. Bei diesem Ausführungsbeispiel können die Sockel 4 aus demselben Material bestehen, aus dem auch die Substrate 3 bestehen. Die Oberfläche des Suszeptors innerhalb des Vertiefungsrandes 16 wird bei diesem Ausführungsbeispiel nahezu ausschließlich von den Sockeloberflächen und den Substratoberflächen gebildet, die identische chemische und physikalische chemische Eigenschaften aufweisen. Hierdurch ist eine Erhöhung der Homogenität der abgeschiedenen Schichten möglich.

Bei dem in der Figur 6 dargestellten dritten Ausführungsbeispiel liegen die Substrate 3 in Einzelvertiefungen 12. Die Zentren 10 der Einzelvertiefungen 12 liegen hier, wie oben bereits beschrieben, auf den Eckpunkten eines Gitters, dessen Gitterzelle die Form eines gleichseitigen Dreiecks besitzt. Die Dreiecksseitenlänge ist nur geringfügig größer als der Durchmesser des Substrates 3 bzw. der Durchmesser der Einzelvertiefung 12. Auch hier sind jeweils drei zueinander benachbarte Einzelvertiefungen einem Sockel 4 benachbart. Zwei benachbarte Sockel 4 sind bei diesem Ausführungsbeispiel aber unter Ausbildung einer Materialbrücke 13 miteinander verbunden. Die Materialbrücke 13 bildet eine Einschnürung aus. Die horizontale minimale Weite der Einschnürung, also die minimale Breite der Materialbrücke 13, entspricht im wesentlichen der Materialstärke des Substrates 3 bzw. der Höhe der Anlageflanke 4, die kontinuierlich ein Substrat 3 umgibt.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Beschichten einer Vielzahl regelmäßig auf einer Auflagefläche (2) eines einer Prozesskammer (14) zugehörigen Suszeptors (1) angeordneter Substrate (3), wobei die Auflagefläche (2) Anlageflanken (5) ausbildet zur Randfassung jedes Substrates (3), **dadurch gekennzeichnet, dass** die Anlageflanken (5) von den Seitenwänden (5) von aus der Auflagefläche (2) ragenden, von einander mit Abstand getrennten Sockeln (4) gebildet sind, die auf den Eckpunkten (10) einer Wabenstruktur angeordnet sind und einen Grundriss aufweisen, der im wesentlichen einem gleichseitigen Dreieck mit einwärts gekrümmten Seiten (5) entspricht, die den Randkanten des auf der jeweiligen Auflagefläche (2) aufliegenden Substrates (3) derart folgen, dass sich benachbarte Substrate (3) berühren können.

2. Vorrichtung nach Anspruch 1, **dadurch gekennzeichnet, dass** die Sockel (4) derart voneinander beabstandet sind, dass sich Randabschnitte (8) benachbarter Substrate (3) berühren oder nahezu berühren.

3. Vorrichtung nach einem der vorangehenden Ansprüche, **dadurch gekennzeichnet, dass** die Sockel (4) in Einstecköffnungen (9) der Auflagefläche (2) eingesteckte Einsatzstücke sind.

4. Vorrichtung nach Anspruch 3, **dadurch gekennzeichnet, dass** die Einsatzstücke aus demselben Material, insbesondere Saphir oder einem anderen Halbleitermaterial, bestehen, aus dem auch die Substrate (3) bestehen.

5. Vorrichtung nach einem der vorangehenden Ansprüche, **dadurch gekennzeichnet, dass** der Suszeptor (1) aus Graphit oder einem Metall oder Quarz besteht.

6. Vorrichtung nach einem der vorangehenden Ansprüche, **dadurch gekennzeichnet, dass** die Höhe der Anlageflanke (5) im wesentlichen der Materialstärke eines Substrates (3) entspricht.

7. Vorrichtung nach einem der vorangehenden Ansprüche, **gekennzeichnet durch** eine oberhalb des horizontalen Suszeptors (1) angeordnete Prozesskammer (14), welche nach oben hin von der Unterseite eines Gaseinlassorganes (15) begrenzt wird, welche nach unten weisende Öffnungen aufweist, die duschkopfartig über die gesamte nach unten weisende Gasaustrittsfläche des Gaseinlassorganes (15) verteilt sind, und aus welchen ein oder mehrere Prozessgase in die Prozesskammer (14) eintreten, um dort entweder in der Gasphase selbst oder von einer unterhalb des Suszeptors (1) angeordneten Heizung thermisch aktiviert auf der Substratoberfläche zu reagieren.

## Claims

1. Device for coating a plurality of substrates (3) that are arranged in a regular manner on a support surface (2) of a susceptor (1) associated with a process chamber (14), the support surface (2) forming abutment flanks (5) for edge engagement of each substrate (3), **characterized in that** the abutment flanks (5) are defined by the side walls (5) of upstands (4) that extend from the support surface (2) and are separated from one another at a spacing, the upstands being located at the corner points (10) of a honeycomb-shaped pattern and having a shape in plan view that substantially corresponds to an equilateral triangle with inwardly curved sides (5) that follow the peripheral edges of the substrate (3) supported on the respective support surface (2) in such a way that neighbouring substrates (3) can contact one another.

2. Device according to Claim 1, **characterized in that** the upstands (4) are spaced apart from one another in such a way that edge portions (8) of neighbouring substrates (3) are in contact or almost in contact.

3. Device according to either of the preceding claims, **characterized in that** the upstands (4) are insertion pieces that are inserted into insertion openings (9) in the support surface (2).

4. Device according to Claim 3, **characterized in that** the insertion pieces consist of the same material as that from which the substrates (3) consist, in particular sapphire or another semi-conductor material.

5. Device according to any of the preceding claims, **characterized in that** the susceptor (1) consists of graphite or a metal or quartz.

6. Device according to any of the preceding claims, **characterized in that** the height of the abutment flank (5) corresponds substantially to the material thickness of a substrate (3).

7. Device according to any of the preceding claims, **characterized by** a process chamber (4) disposed above the horizontal susceptor (1), the process chamber being delimited upwardly by the underside of a gas inlet member (15), the gas inlet member having downwardly-facing openings which are distributed in the manner of a shower head over the entire downwardly-facing gas exit surface of the gas inlet member (15), and from which openings, one or more process gases enter the process chamber (14), in order there to react on the upper surface of the substrate either of their volition in the gas phase or thermally activated by a heater located underneath the susceptor (1).

## Revendications

1. Dispositif de revêtement d'un grand nombre de substrats (3) disposés régulièrement sur une surface de support (2) d'un suscepteur (1) associé à une chambre de réaction (14), la surface de support (2) formant des flancs de maintien (5) destiné maintenir chaque substrat (3) au niveau des bords, **caractérisé en ce que** les flancs de maintien (5) sont formés par les parois latérales (5) d'embases (4), saillant de la surface de support (2) et distantes l'une de l'autre, qui sont disposées aux coins (10) d'une structure alvéolaire et qui présentent une projection correspondant sensiblement à un triangle équilatéral dont les côtés (5) sont incurvés vers l'intérieur et suivent les arêtes du substrat (3) reposant sur la surface de support correspondante (2) de telle sorte que des substrats adjacents peuvent se toucher.

2. Dispositif selon la revendication 1, **caractérisé en ce que** les embases (4) sont espacées l'une de l'autre de telle façon que des portions de bord (8) de substrats adjacents (3) se touchent ou presque.

3. Dispositif selon l'une des revendications précédentes, **caractérisé en ce que** les embases (4) sont des inserts insérés dans des ouvertures d'insertion (9) de la surface de support (2).

4. Dispositif selon la revendication 3, **caractérisé en ce que** les inserts sont en le même matériau, notamment du saphir ou un autre matériau semi-conducteur, que les substrats (3).

5. Dispositif selon l'une des revendications précédentes, **caractérisé en ce que** le suscepteur (1) est en graphite ou en métal ou en quartz.

6. Dispositif selon l'une des revendications précédentes, **caractérisé en ce que** la hauteur des flancs de maintien (5) correspond sensiblement à l'épaisseur de matériau d'un substrat (3).

7. Dispositif selon l'une des revendications précédentes, **caractérisé par** une chambre de réaction (14) qui est disposée au-dessus du suscepteur horizontal (1), qui est délimitée vers le haut par le côté inférieur d'un organe d'introduction de gaz (15), qui comporte des ouvertures, dirigées vers le bas, qui sont réparties en pomme de douche sur toute la surface de sortie de gaz, dirigée vers le bas, de l'organe d'introduction de gaz et qui permettent à un ou plusieurs gaz de réaction d'entrer dans la chambre de réaction (14) pour réagir sur la surface des substrats soit dans la phase gazeuse elle-même soit par activation thermique au moyen d'un chauffage placé au-dessous du suscepteur (1).
